# EUROPEAN PATENT APPLICATION

(11) **EP 2 432 003 A2**
(43) Date of publication of application: **21.03.2012**
(21) Application number: 11181275.6
(22) Date of filing: 14.09.2011
(51) Int. Cl.: H01L 21/28, H01L 29/78, H03K 17/082

(54) **Silicon Carbide Semiconductor Device**

(30) Priority: 17.09.2010 GB 1015595
(71) Applicant: GE Aviation Systems Limited, Bishops Cleeve Cheltenham Gloucestershire GL52 8SF (GB)
(72) Inventor: Shipley, Adrian, Cheltenham, Gloucestershire GL52 8SF (GB); Mawby, Philip, Coventry, CV4 7AL (GB); Covington, James, Coventry, CV4 7AL (GB); Jennings, Michael, Coventry, CV4 7AL (GB); Stevens, Martin, Cheltenham, Gloucestershire GL53 0DQ (GB)
(74) Representative: Gray, Thomas

(57) **Abstract**

A method of manufacturing a semiconductor device comprises applying a first layer (18) comprising silicon to a second layer (15) comprising silicon carbide, whereby an interface is defined between the first and second layers, and oxidising some or all of the first layer (16).

## Description

The invention relates to semiconductor devices manufactured with silicon carbide and methods of manufacturing such devices. One particular application of the invention is in the manufacture of MOSFETs (metal-oxide-semiconductor field effect transistors) using silicon carbide. The invention also relates to aircraft power distribution systems that utilise such MOSFETs.

### BACKGROUND

The use of silicon carbide, SiC, in the manufacture of MOSFETs provides a number of benefits over traditional silicon substrates. For example, SiC has very high strength and does not melt at any known pressure and is chemically highly stable. Further, SiC allows the production of devices having a lower on-state resistance than silicon devices. Thus SiC lends itself to use in high power MOSFETs.

One problem associated with the manufacture of MOSFETS using SiC is that it has not been possible to make a channel region of the MOSFET with high enough quality to produce viable devices that are sufficiently reliable for practical use. In a MOSFET, the channel region lies beneath the oxide layer at the gate of the MOSFET, and when the MOSFET is switched on the channel region allows the flow of current through the device. Previous attempts to produce SiC MOSFETs have been subject to the problem of carbon gettering at the interface, whereby carbon impurities are formed at the interface, adversely affecting the electrical behaviour of the device.

US5,744,826 discloses a process for producing silicon carbide semiconductor devices, such as MOSFETs, wherein a gate insulating film is formed on the surface of a SiC semiconductor layer, by thermal oxidation of the SiC layer.

In order to provide the required electrical properties in the channel region, it is important that a good quality interface is defined between the oxide and the SiC beneath it. The present invention provides a method of manufacturing a semiconductor device comprising applying a first layer comprising silicon to a second layer comprising silicon carbide, whereby an interface is defined between the first and second layers, and oxidising some or all of the first layer.

By virtue of applying the first layer comprising silicon to the second layer comprising SiC, the quality of each surface of the first and second layers can be independently ensured, thereby resulting in high quality of each surface, and especially the interface between the layers. Further, as this process does not oxidise any SiC, the problems associated with carbon gettering at the interface are overcome. Thus the interface provided by the present invention is of high quality. Naturally, great care is needed in the preparation of the SiC layer as high levels of cleanliness and flatness are desired.

Wafer bonding can be used to attach the first and second layers to one another. In wafer bonding, a thin layer of single crystal silicon is transferred from a carrier wafer on to the surface of another target wafer, in this case the SiC layer. The transferred layer is of high quality, so it can be oxidised to form an oxide of correspondingly high quality.

Further, the present invention provides a semiconductor device manufactured according to the above described method comprising a first layer comprising SiO₂ joined to a second layer comprising silicon carbide, whereby an interface is defined between the first and second layers. Additionally, the invention provides an aircraft power distribution system including such a semiconductor device.

There follows a detailed description of embodiments of the invention by way of example only with reference to the accompanying drawings, in which:
Fig.1 is a schematic simplified view of a field effect transistor such as a MOSFET;
Fig.2 is a cross-sectional view illustrating the problem of carbon gettering;
Fig. 3 illustrates an arrangement of layers according to an embodiment of the invention;
Figs 4A, 4B, 4C and 4D illustrate the stages of a process according to an embodiment of the invention; and
Fig. 5 illustrates a further stage in a process according to an embodiment of the invention.

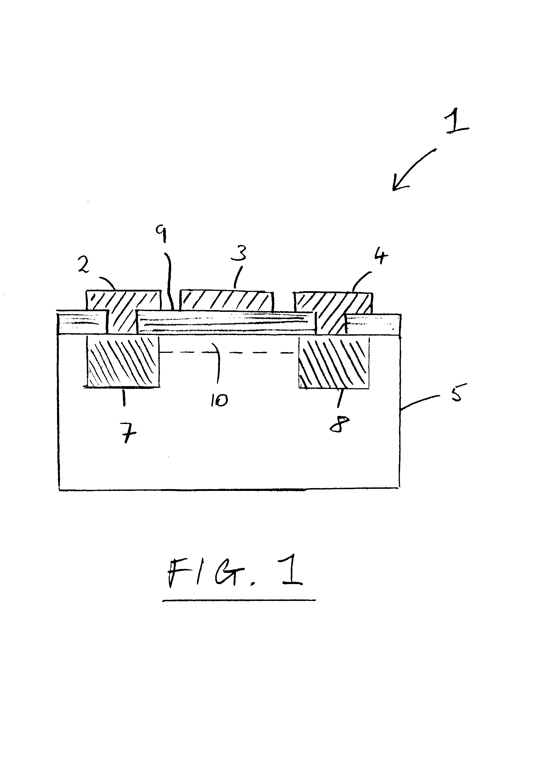

Fig. 1 shows a basic structure of a prior art field effect transistor 1, such as a MOSFET, which comprises a source 2, a drain 4 and a gate 3, each of which includes an electrically conductive contact. A layer 9 of an electrical insulator such as an oxide, for example silicon dioxide, is provided between the source 2, the drain 4, the gate 3 and a substrate 5. Adjacent to the layer 9, when the MOSFET is switched on by applying a potential to the gate 3, a conductive channel 10 is formed in the substrate 5, allowing current to flow between the source 2 and the drain 4. In an n-channel MOSFET, the substrate 5 comprises a p-type material and the source 2 includes a first region 7 of n-type material, whilst the drain 4 includes a second region 8 of n-type material. In order to switch on the n-channel MOSFET, a positive electrical potential is applied to the gate 3, thereby attracting negative charge carriers towards the nonconductive layer 9, and if the applied potential exceeds the threshold for switching the device on, a channel 10 of essentially n-type material is formed. A continuous conduction path of n-type material is thereby provided between the source 2 and the drain 4 allowing current to flow therebetween. Upon removal of the potential at the gate 3, the charge carrier distribution within the substrate 5 reverts to its normal state, thereby removing the conductive channel 10 and switching the device off. The present invention is also applicable to p-channel MOSFETs wherein the p-type and n-type materials are arranged in an opposite configuration to that just described. In general terms, the invention is applicable to any type of MOSFET, or other semiconductor devices which require an interface between a semiconducting layer and an insulating layer.

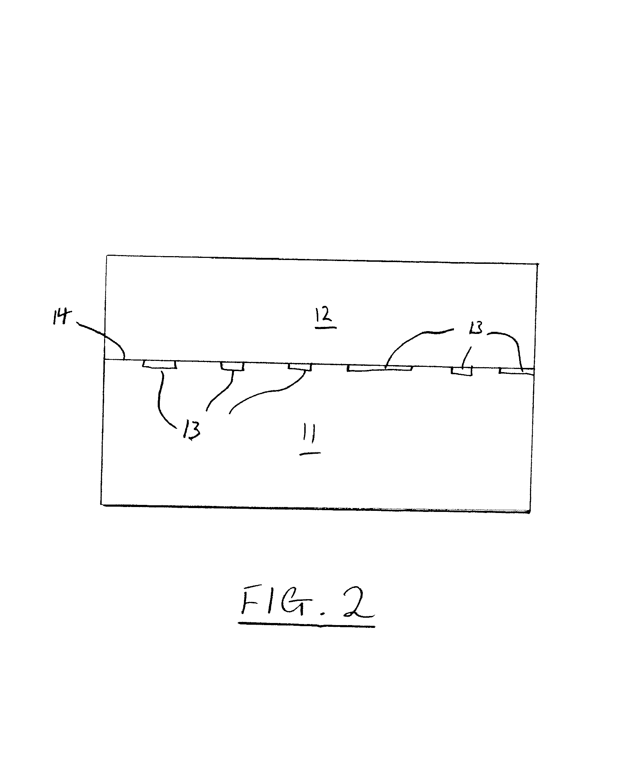

Fig. 2 is a cross-sectional view illustrating the problem with oxidising SiC directly. Depending on reaction conditions, the oxidation of SiC generally produces a layer of SiO₂ 12 on top of the layer of SiC 11 that is being oxidised. Other non-stoichiometric oxides of silicon may be present in the SiO₂ layer 12. Carbon clusters 13 are formed at an interface 14 between the SiC layer 11 and the SiO₂ layer 12, to the detriment of the electrical properties of the arrangement.

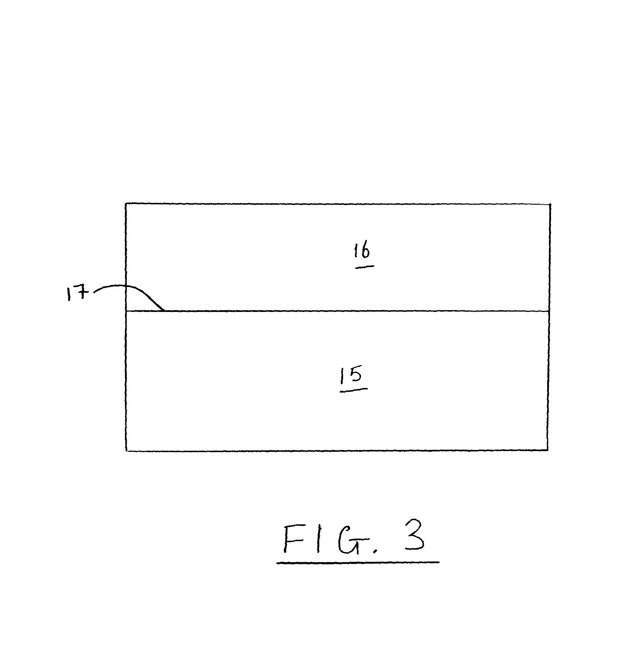

Fig. 3 is a cross-sectional view of part of a semiconductor device embodying the invention, comprising a first layer 16 of SiO₂ disposed on a second layer 15 of SiC. No carbon clusters are present at the interface 17, because the device was manufactured according to the method of the invention.

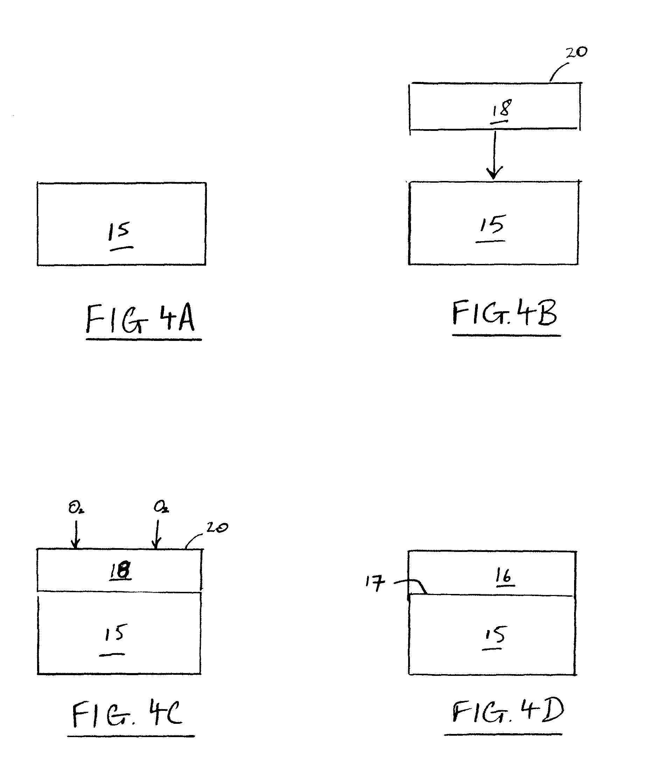

Figures 4A, 4B, 4C and 4D are cross-sectional views showing the stages of a method embodying the invention. As shown in Fig. 4A, the starting point is a layer of SiC 15.

In Fig. 4B, a layer 18 of Si is wafer bonded to the layer of SiC 15. In Fig. 4C, the wafer bonded layer 18 of Si is oxidised. Oxygen reacts with the Si layer 18 from its outer surface 20 inwards, wherein an at least partially oxidised layer 18 of Si is formed. The degree of oxidation of the layer 18 can be controlled for example by performing the oxidation for a predetermined time at a known oxidation rate.

Alternatively or additionally, the oxidation can be carried out at a temperature great enough to oxidise Si but not to oxidise SiC. This ensures that no oxidation of the SiC layer 15 takes place. The oxidation can be continued until the Si layer is fully oxidised. Alternatively, a layer of unoxidised Si may be left between the SiC and the oxidised layer of Si, by terminating the oxidation before the Si layer is fully oxidised.

This provides another way of ensuring that the layer of SiC is not oxidised during the process. Fig. 4D shows the arrangement of layers after the oxidation process is completed, wherein a layer 16 of SiO₂ is provided on the layer 15 of SiC.

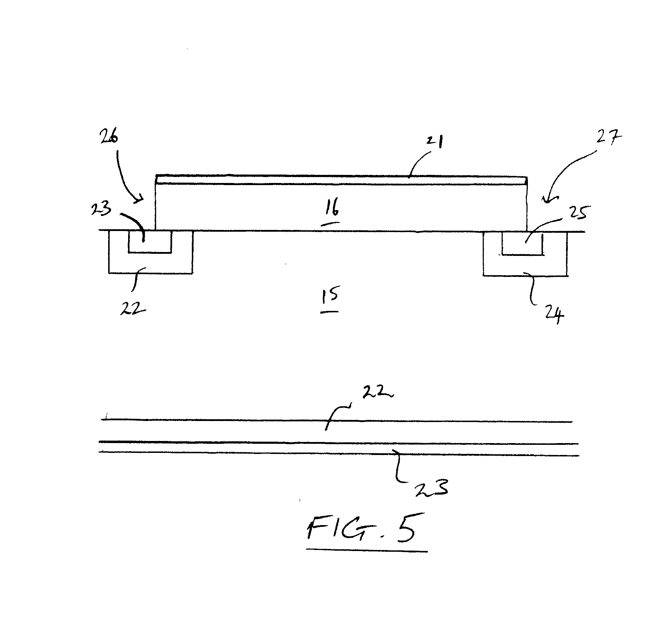

Following the completion of the oxidation process, the SiO₂ layer 16 is etched away in regions 26,27 shown in Fig 5, to expose first and second regions 23,25 of heavily doped n-type SiC and first and second regions 22,24 of doped p-type SiC in the SiC layer 15. For simplicity the regions 22 to 25 are not shown in Figs 4A to 4D. The rest of the SiC layer 15 comprises moderately doped n-type SiC, and in particular can consist of a single crystal of SiC. A source contact (not shown) is provided in the regions 26 and 27, whilst a drain contact 23 is provided on the opposite side of the device. A layer 22 of heavily doped n-type SiC is provided between the SiC layer 15 and the drain contact 23. The gate electrode 21 is provided on the layer 16 of SiO₂. The contacts can be made of any good electrical conductor, for example Nickel.

SiC MOSFETs embodying the present invention are particularly suited for use in aircraft power distribution systems. The issue of aircraft wiring safety has received widespread attention in recent years. Both "smoke in the cockpit" and arcing events are relevant here, and efforts are being made to improve the safety of such systems. Aircraft electric power systems are exposed to a wide range of disturbances, which may initiate such events. These include current and voltage transients and short-circuit conditions, arising from equipment failure and lightning strikes, for example. Electro-mechanical circuit breakers have traditionally been used to protect against such faults; however many of the faults are below the time protection curve threshold designed to protect the power system.

SSPC's (Solid State Power Controllers) can replace electro-mechanical controllers and provide improved performance, including very fast response, limiting the fault current within safe limits, and a long multi-operation life span. They further allow a flexible construction and control scheme, being fully controllable for both functions of current limiting and interruption. SSPCs also are of low cost and require minimal maintenance.

Generally, MOSFETs have a very low on-state resistance, allowing a low voltage drop and hence a small power dissipation (as heat) during operation. However, in order to be able to withstand the short-circuit or fault current for the designated time, a plurality of MOSFETs may have to be placed in parallel to enable the devices to withstand the associated energy losses. There are two principal constraints in action: (1) The steady-state cooling requirements, i.e. size, mass and heat transfer, are defined by normal operation, and (2) the number of devices in parallel is defined by fault conditions; in this case the high power dissipation levels will not act for long enough to heat up the external contact to the devices (i.e. the case), due to the short time of action and the diffusion of heat from the semiconductor device itself to the case. In other words, if there are not enough SSPCs provided in the system, excessive heating can occur during fault conditions. Reducing the number of parallel MOSFETs, and thus giving improvements in size and mass, would be acceptable for normal operation; however this would not allow the fault conditions to be safely contained. MOSFET devices manufactured using SiC as provided by the present invention provide a solution to this problem as they have a much smaller on-state resistance than corresponding Si devices. Improved sensitivity to fault currents can thereby be provided, as well as reduced I²R heating. Silicon carbide is also a much better thermal conductor and has a higher melting/sublimation temperature than Si and so is able to run hotter, thus reducing the requirement for heavy heatsink arrangements. Together, the material advantages of silicon carbide allow much higher power densities to be achieved.

## Claims

1. A method of manufacturing a semiconductor device comprising applying a first layer comprising silicon to a second layer comprising silicon carbide, whereby an interface is defined between the first and second layers, and oxidising some or all of the first layer.

2. A method according to claim 1, wherein the first layer is wafer bonded to the second layer.

3. A method according to claim 1 or 2, wherein the second layer consists of a single crystal of SiC.

4. A method according to any of the preceding claims, wherein the first layer consists of a single crystal of Si.

5. A method according to any of claims 1 to 4, wherein the step of oxidising some or all of the first layer is carried out after the first layer is applied to the second layer.

6. A method according to any of claims 1 to 4, wherein the step of oxidising some or all of the first layer is carried out before or while the first layer is applied to the second layer.

7. A semiconductor device manufactured in accordance with the method of any of claim 1 to 6, comprising a first layer comprising SiO₂ joined to a second layer comprising silicon carbide, whereby an interface is defined between the first and second layers.

8. A semiconductor device according to claim 7 comprising a MOSFET.

9. An aircraft power distribution system comprising a semiconductor device according to claim 7 or 8.

10. A method of manufacturing a semiconductor device substantially as herein described with reference to the accompanying drawings.
